# EUROPÄISCHE PATENTSCHRIFT

(11) **EP 3 018 718 B1**
(45) Veröffentlichungstag und Bekanntmachung des Hinweises auf die Patenterteilung: **31.12.2025**
(21) Anmeldenummer: 14003768.0
(22) Anmeldetag: 10.11.2014
(51) Int. Cl.: H10F 10/142, H10F 77/124

(54) **Solarzellenstapel**
Solar cell stack
Piles de cellules solaires

(43) Veröffentlichungstag der Anmeldung: 11.05.2016
(73) Patentinhaber: AZUR SPACE Solar Power GmbH, 74072 Heilbronn (DE)
(72) Erfinder: Fuhrmann, Daniel, 74074 Heilbronn (DE); Guter, Wolfgang, 70190 Stuttgart (DE)
(74) Vertreter: Koch Müller Patentanwaltsgesellschaft mbH

(56) Entgegenhaltungen:
- EP-A1- 2 395 564
- DE-B3- 102013 000 882
- US-A1- 2004 079 408
- US-A1- 2011 220 190
- HECTOR COTAL ET AL: "III-V multijunction solar cells for concentrating photovoltaics", ENERGY & ENVIRONMENTAL SCIENCE, vol. 2, no. 2, 10 December 2008 (2008-12-10), pages 174, XP055033873, ISSN: 1754-5692, DOI: 10.1039/b809257e
- LI K L ET AL: "Effects of Si doping on the strain relaxation of metamorphic (Al)GaInP buffers grown on GaAs substrates", APPLIED SURFACE SCIENCE, vol. 288, 18 October 2013 (2013-10-18), pages 482 - 487, XP028780732, ISSN: 0169-4332, DOI: 10.1016/J.APSUSC.2013.10.058
- TANGRING I ET AL: "A study of the doping influence on strain relaxation of graded composition InGaAs layers grown by molecular beam epitaxy", JOURNAL OF CRYSTAL GROWTH, ELSEVIER, AMSTERDAM, NL, vol. 311, no. 7, 15 March 2009 (2009-03-15), pages 1684 - 1687, XP026065714, ISSN: 0022-0248, [retrieved on 20081117], DOI: 10.1016/J.JCRYSGRO.2008.11.019
- V. KLINGER ET AL: "Determination of hardness and Young's modulus for important III-V compound semiconductors", THIN SOLID FILMS, vol. 548, 29 August 2013 (2013-08-29), pages 358 - 365, XP055156264, ISSN: 0040-6090, DOI: 10.1016/j.tsf.2013.08.079
- TOBIAS ROESENER: "Hocheffiziente III-V-Mehrfachsolarzellen auf Silicium Substrat", DISSERTATION, 1 January 2013 (2013-01-01), XP055155900, Retrieved from the Internet <URL:http://www.reiner-lemoine-stiftung.de/pdf/dissertationen/dissertation_roesener.pdf> [retrieved on 20141201]

## Beschreibung

Die Erfindung betrifft einen Solarzellenstapel.

Um mit Solarzellen möglichst hohe Effizienzen für die Umwandlung von Sonnenlicht in elektrische Energie zu erreichen, werden seit einigen Jahren Mehrfachsolarzellen aus unterschiedlichen Halbleitermaterialien untersucht [W. Guter, Optimierung von III-V basierten Hochleistungssolarzellen, Dissertation, Uni Konstanz, Fakultät für Physik, 2011]. Mehrfachsolarzellen teilen das einfallende Licht auf mehrere übereinander gestapelte Teilsolarzellen mit unterschiedlicher Bandlückenenergie auf. Um höchste Effizienzen zu erreichen, müssen die Halbleitermaterialien und deren Bandlückenenergie an einander angepasst werden, so dass vorzugsweise jede der elektrisch in Serie verschalteten Teilsolarzellen möglichst den gleichen Strom generiert.

Sofern die Halbleitermaterialien der einzelnen Teilzellen des Stapels die gleiche Gitterkonstante aufweisen, lassen sich die Teilzellen mittels eines epitaktischen Verfahrens herstellen. Aus Meusel et al., III-V MULTIJUNCTION SOLAR CELLS - FROM CURRENT SPACE AND TERRESTRIAL PRODUCTS TO MODERN CELL ARCHITECTURES, 5th WCPEC, 2010, Valencia, 1AP.1.5 ist eine gitterangepasste 4-fach Solarzelle aus AlInGaP, InGaAs, InGaNAs und Ge bekannt. Aus Gründen der Kristallqualität insbesondere von der InGaNAs Teilzelle werden nur unzureichende Wirkungsgrade erreicht.

Weisen die Teilzellen unterschiedliche Gitterkonstanten auf, werden in einer ersten Alternative zwischen zwei Teilzellen metamorphe Pufferschichten eingesetzt. Aus Guter et al., DEVELOPMENT, QUALIFICATION AND PRODUCTION OF SPACE SOLAR CELLS WITH 30% EOL EFFICIENCY, European Space Power Conference, 2014, Noordwijkerhout, The Netherlands ist eine Abfolge von Teilzellen aus AlInGaP, AlInGaAs, InGaAs, einem metamorphen Puffer und Ge bekannt. Ferner ist aus Cornfeld et al., Development of a four sub-cell inverted metamorphic multi-junction (IMM) highly efficient AM0 solar cell, 35th IEEE PVSC, 2010, Honolulu, USA eine weitere Abfolge von Teilzellen aus InGaP, GaAs mit einem ersten metamorphen Puffer, einer ersten InGaAs Teilzelle und einem zweiten metamorphen Puffer und einer zweiten InGaAs Teilzelle bekannt.

Aus der US 2011/220190 A1 ist ein Solarzellenstapel mit einem Puffer und unterschiedlichen Dotierungen bekannt. Weitere Mehrfachsolarzellen teilweise mit Puffern sind aus Hector Cotal et al: "III_V mulitjunction solar cell for concentrating photovoltaics". Energy & Environmental Science, Bd. 2 Nr. 2,1 Januar 2009, Seite 174, ISSN: 1754-5692, und aus Li K L Et al: "Effects of Si doping on the strain relaxation of metamorphic (AL)GaInP buffers grown on GaAs substrates", Applied surface science, Bd. 288, Seiten 482-487, ISSN: 0169-4332, und aus Tangring et al: "A study of the doping influence on strain relaxation of graded composition in GaAs Layers grown ba molecular beam epitaxy", Journal of crystal growth, Elsevier, Amsterdam, NL, Bd. 311, Nr. 7, 15. März 2009, Seiten 1684-1687, ISSN oo22-0248, und aus DE 10 2013 000882 B3, und aus V. Klinger et al: "Determination of hardness and Young's modulus for important III_V compound semiconductors", Thin solid films, Bd. 548, 29. August 2013, Seiten 358-365, ISSN 0040-6090, bekannt.

Des Weiteren ist aus der US 2004/0079408 A1 eine III-V metamorphe Mehrfachsolarzelle mit einer Ge-Substratteilzelle bekannt, wobei der metamorphe Puffer zwischen der Ge-Teilzelle und einer darauffolgenden InGaAs Teilzelle ausgebildet ist. Hierbei ist bekannt, dass die Gitterkonstante der Pufferschichten zwischen der ersten Teilzelle hin zu der zweiten Teilzelle ansteigt und die Dotierung des Puffers die Härte der Pufferschichten und das Relaxationsverhalten beeinflusst.

Vor diesem Hintergrund besteht die Aufgabe der Erfindung darin, eine Vorrichtung anzugeben, die den Stand der Technik weiterbildet.

Die Aufgabe wird durch einen Solarzellenstapel mit den Merkmalen des Patentanspruchs 1 gelöst. Vorteilhafte Ausgestaltungen der Erfindung sind Gegenstand von Unteransprüchen.

Gemäß dem Gegenstand der Erfindung wird ein Solarzellenstapel bereitgestellt, aufweisend eine erste Halbleiter-Solarzelle, wobei die erste Halbleiter-Solarzelle einen p-n Übergang aus einem ersten Material mit einer ersten Gitterkonstanten aufweist, und eine zweite Halbleiter-Solarzelle, wobei die zweite Halbleiter-Solarzelle einen p-n Übergang aus einem zweiten Material mit einer zweiten Gitterkonstanten aufweist, und die erste Gitterkonstante um mindestens 0,008 Å kleiner als die zweite Gitterkonstante ist, und einen metamorphen Puffer, wobei der metamorphe Puffer zwischen der ersten Halbleiter-Solarzelle und der zweiten Halbleiter-Solarzelle ausgebildet ist, und der metamorphe Puffer eine Abfolge von drei Schichten umfasst und die Gitterkonstante bei der Abfolge in Richtung der zweiten Halbleitersolarzelle ansteigt, und die Gitterkonstanten der Schichten des metamorphen Puffers größer als die erste Gitterkonstante sind, wobei zwei Schichten des Puffers eine Dotierung aufweisen, und wobei der Unterschied in der Dotierstoffkonzentration zwischen den beiden Schichten größer als 4E17 cm-³ ist.

Aus Gründen der Klarheit sei angemerkt, dass die erste Halbleiter-Solarzelle im Vergleich zu der zweiten Halbleiter-Solarzelle eine kleinere Gitterkonstante aufweist. Nachfolgend wird für den Begriff der Halbleiter-Solarzelle auch der Begriff der Teilzelle synonym verwendet. Es versteht sich, dass die Teilzelle mit der größten Bandlückenenergie auf der der Sonne zugewandten Seite des Solarzellenstapels ausgebildet ist. Nachfolgend wird für den Begriff "Solarzellenstapel" auch synonym der Begriff "stapelförmigen integrierten Mehrfachsolarzelle" verwendet.

Nach dem Durchlaufen des Lichtes durch die Halbleiter-Solarzelle mit der größten Bandlückenenergie, trifft das nicht absorbierte Licht also der langwelligere Bereich auf die Halbleiter-Solarzelle mit einer kleineren Bandlückenenergie. Sofern ein Trägersubstrat für den Solarzellenstapel vorhanden ist, ist das Trägersubstrat immer mit der Teilzelle mit der kleinsten Bandlückenenergie verbunden. Es sei angemerkt, dass die beiden Halbleiter-Solarzellen zusammen monolithisch integriert sind.

Vorliegend wird unter dem Begriff der Dotierstoffkonzentration der durchschnittliche Wert der Dotierstoffe In der jeweiligen Schicht des Puffers, verstanden.

Ein Vorteil ist es, dass der erfindungsgemäße Solarzellenstapel einen hohen Wirkungsgrad aufweist, indem mittels eines metamorphen Puffers zwei Solarzellen mit unterschiedlichen Gitterkonstanten aufeinander gestapelt werden. Untersuchungen haben gezeigt, dass eine Dotierung im Bereich des Puffers die Anzahl der Versetzungen wesentlich reduziert, d.h. die dotierten Schichten des metamorphen Puffers härter werden. Auch lassen sich mit einem metamorphen Puffer von hoher Güte, d.h. Unterdrückung der Ausbreitung von Versetzungen des Puffers in die umliegenden aktiven Gebiete, die Bandlückenenergien derart auswählen, dass sich der Gesamtwirkungsgrad des erfindungsgemäßen Solarzellenstapels, gegenüber einem Stapel aus gitterangepassten Solarzellen erhöht.

In einer Weiterbildung weist wenigstens eine Schicht des metamorphen Puffers eine vierte Gitterkonstante auf, wobei die vierte Gitterkonstante größer ist als die Gitterkonstante der zweiten Halbleiter-Solarzelle, Es ist bevorzugt, dass die Gitterkonstante bei den Schichten des metamorphen Puffers in Richtung der zweiten Halbleiter-Solarzelle von Schicht zu Schicht um jeweils mindestens 0,003 Å ansteigt.

In einer bevorzugten Ausführungsform weisen bei dem metamorphen Puffer bei zwei unmittelbar aufeinanderfolgenden Schichten die beiden Schichten eine unterschiedliche Konzentration der Dotierstoffe auf.

In einer weiteren Ausführungsform ist bei zwei unmittelbar aufeinanderfolgenden Schichten des Puffers der Unterschied in der Konzentration der Dotierstoffe größer als der Faktor fünf, vorzugsweise größer als der Faktor 7, höchst vorzugsweise größer als der Faktor 10. Es versteht sich, dass die Schichten des metamorphen Puffers entweder eine n-Dotierung oder eine p-Dotierung aufweisen.

Vorzugsweise sind im metamorphen Puffer als p-Dotierstoffe Zn und / oder C und / oder Mg und / oder Be und als n-Dotierstoffe Si und / oder Te und/ oder Se vorgesehen. Untersuchungen haben gezeigt, dass die Konzentration der Dotierstoffe innerhalb der jeweiligen Schicht des metamorphen Puffers im Wesentlichen konstant, vorzugsweise konstant ist.

Erfindungsgemäß umfasst der metamorphe Puffer wenigstens fünf Schichten, vorzugsweise wenigstens sechs Schichten.

In einer bevorzugten Ausführungsform weisen zwei Schichten des metamorphen Puffers die gleiche Konzentration der Dotierstoffe auf. Vorzugsweise sind die beiden Schichten stoffschlüssig miteinander verbunden.

In einer anderen Weiterbildung nimmt bei einer Abfolge von mehreren Schichten des metamorphen Puffers die Konzentration der Dotierstoffe von Schicht zu Schicht zuerst zu und anschließend wieder ab. Vorteilhaft ist, wenn die Konzentration der Dotierstoffe innerhalb der metamorphen Pufferschichten 1E19 cm⁻³, höchst vorzugsweise 0.5E19cm⁻³ nicht überschreitet.

Es versteht sich, dass die metamorphen Pufferschichten nicht Teil eines pn-Übergangs einer Tunneldiode sind.

In einer besonders vorteilhaften Ausführung ist als Substratschicht Ge oder GaAs vorgesehen, wobei die erste Halbleiter-Solarzelle und/oder die zweite Halbleiter-Solarzelle aus den Materialien Ge und/oder GaAs und/oder InGaAs und/oder InGaP bestehen.

In einer Weiterbildung sind alle Solarzellen des Stapels monolithisch integriert und / oder es ist ein optischer Rückseitenspiegel ausgebildet. Es versteht sich, dass der optische Rückseitenspiegel unterhalb der Halbleiter-Solarzelle mit der kleinsten Bandlückenenergie angeordnet ist. Bevorzugt ist, den optischen Rückseitenspiegel aus einem Metall auszubilden. Mittels des Rückseitenspiegels lassen sich die nichtabsorbierten Photonen in die Halbleiter-Solarzelle mit der kleinsten Bandlückenenergie zurückreflektieren und der optische Weg vergrößern.

Die Erfindung wird nachfolgend unter Bezugnahme auf die Zeichnungen näher erläutert. Hierbei werden gleichartige Teile mit identischen Bezeichnungen beschriftet. Die dargestellten Ausführungsformen sind stark schematisiert, d.h. die Abstände und die lateralen und die vertikalen Erstreckungen sind nicht maßstäblich und weisen, sofern nicht anders angegeben, auch keine ableitbaren geometrischen Relationen zueinander auf. Darin zeigt:
- Figur 1a: eine erste Ausführungsform eines metamorphen Puffers in Zusammenhang mit einer zweifach Halbleiter-Solarzelle,
- Figur 1b: Verlauf der Gitterkonstante für zweifach Halbleiter-Solarzelle, dargestellt in der Figur 1a,
- Figur 1c: Verlauf der Dotierung für die erste Ausführungsform des Puffers, dargestellt in der Figur 1a,
- Figur 2a: eine zweite Ausführungsform des metamorphen Puffers,
- Figur 2b: Verlauf der Dotierung für die zweite Ausführungsform des metamorphen Puffers, dargestellt in der Figur 2a,
- Figur 2c: Verlauf der Härte für die zweite Ausführungsform des Puffers, dargestellt in der Figur 2a,
- Figur 3a: eine dritte Ausführungsform des metamorphen Puffers,
- Figur 3b: den Verlauf der Dotierung für die dritte Ausführungsform des metamorphen Puffers, dargestellt in der Figur 3a,
- Figur 3c: einen alternativen Verlauf der Dotierung für die dritte Ausführungsform des Puffers, dargestellt in der Figur 3a,

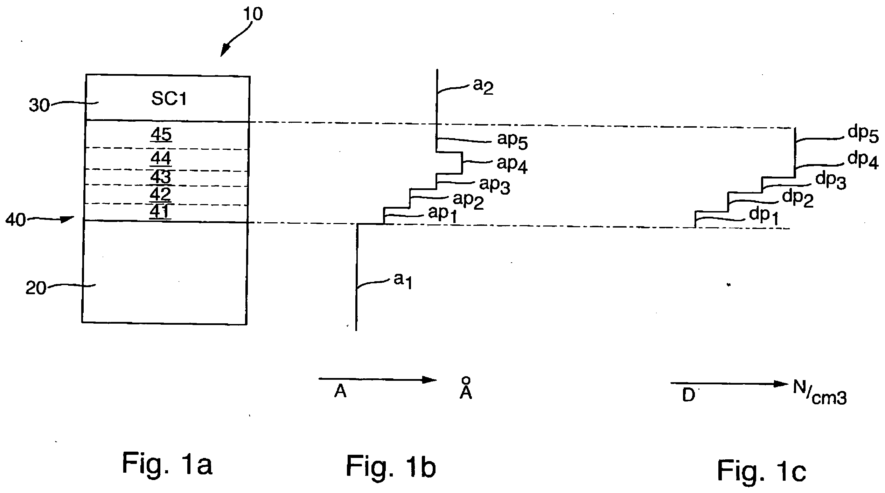

Die Abbildung der Figur 1a zeigt einen Solarzellenstapel 10 mit einer ersten Halbleiter-Solarzelle 20 und einer zweiten Halbleiter-Solarzelle 30 und einem zwischen der Halbleiter-Solarzelle 20 und einer zweiten Halbleiter-Solarzelle 30 ausgebildeten metamorphen Puffer 40.

Die erste Halbleiter-Solarzelle 20 weist einen p-n Übergang aus einem ersten Material mit einer ersten Gitterkonstanten a1 und einer ersten Bandlückenenergie Eg1 auf. Die zweite Halbleiter-Solarzelle 30 weist einen p-n Übergang aus einem zweiten Material mit einer zweiten Gitterkonstanten a2 mit einer zweiten Bandlückenenergie Eg2 auf. Die zweite Gitterkonstante a2 ist größer als die erste Gitterkonstante a1. Die Sonnenlichteinstrahlung erfolgt durch die zweite Halbleiter-Solarzelle 30 und durchdringt anschließend den Puffer und trifft hiernach auf die erste Halbleiter-Solarzelle 20. In einer nicht dargestellten Ausführungsform erfolgt die Sonnenlichteinstrahlung durch die erste Halbleiter-Solarzelle 20 und durchdringt anschließend den Puffer und trifft hiernach auf die zweite Halbleitersolarzelle 30.

Der Puffer 40 weist vorliegend eine Abfolge von fünf Schichten 41, 42, 43, 44 und 45 auf, wobei die erste Schicht 41 des Puffers 40 zwischen der ersten Halbleiter-Solarzelle 20 und der zweiten Schicht 42 des Puffers 40 angeordnet ist und die dritte Schicht 43 des Puffers 40 zwischen der zweiten Schicht 42 des Puffers 40 und der vierten Schicht 44 des Puffers 40 angeordnet ist und die vierte Schicht 44 des Puffers 40 zwischen der dritten Schicht 43 des Puffers 40 und der fünften Schicht 45 des Puffers 40 angeordnet ist und die fünfte Schicht 45 des Puffers 40 zwischen der vierten Schicht 44 des Puffers 40 und der zweiten Halbleiter-Solarzelle 30 angeordnet ist. In einer nicht dargestellten Ausführungsform weist der metamorphe Puffer 40 sechs oder mehr Schichten auf. In einer anderen auch nicht dargestellten Ausführungsform weist der Puffer 40 drei oder vier Schichten auf.

Die Abbildung der Figur 1b zeigt den Verlauf der Gitterkonstante A in der Einheit Å für den Solarzellenstapel der zweifach Halbleiter-Solarzelle 10, dargestellt in der Figur 1a. Nachfolgend werden nur die Unterschiede zu der Ausführungsform, dargestellt in der Abbildung der Figur 1a, erläutert. Die erste Halbleiter-Solarzelle 20 weist die erste Gitterkonstante a1 auf, wobei für die gesamte erste Halbleiter-Solarzelle 20 die erste Gitterkonstante a1 konstant ist.

An dem Übergang von der ersten Halbleiter-Solarzelle 20 zu der ersten Schicht 41 des Puffers 40 springt die Gitterkonstante A auf eine Gitterkonstante ap1 der ersten Schicht 41, wobei die Gitterkonstante ap1 der ersten Schicht 41 größer ist als die Gitterkonstante a1 der ersten Halbleiter-Solarzelle 20.

An dem Übergang von der ersten Schicht 41 zu der zweiten Schicht 42 springt die Gitterkonstante A auf eine im Vergleich zu der Gitterkonstante ap1 der ersten Schicht 41 größere Gitterkonstante ap2 der zweiten Schicht 42, wobei die Gitterkonstante A von Schicht zu Schicht des Puffers 40 um jeweils mindestens 0,003 Å ansteigt.

An dem Übergang von der zweiten Schicht 42 zu der dritten Schicht 43 springt die Gitterkonstante A auf eine im Vergleich zu der Gitterkonstante ap2 der zweiten Schicht 42 größere Gitterkonstante ap3 der dritten Schicht 43.

An dem Übergang von der dritten Schicht 43 zu der vierten Schicht 44 springt die Gitterkonstante A auf eine im Vergleich zu der Gitterkonstante ap3 der dritten Schicht 43 größere Gitterkonstante ap4 der vierten Schicht 44.

An dem Übergang von der vierten Schicht 44 zu der fünften Schicht 45 springt die Gitterkonstante A auf eine im Vergleich zu der Gitterkonstante ap4 der vierten Schicht 44 kleinere Gitterkonstante ap5 der fünften Schicht 45, wobei die Gitterkonstante ap5 der fünften Schicht 45 gleich groß wie die zweite Gitterkonstante a2 der zweiten Halbleiter-Solarzelle 30 ist. Indem die Gitterkonstante der vierten Schicht 44 am Größten innerhalb des Puffers 40 und insbesondere größer als die zweite Gitterkonstante a2 ist, wird eine hohe Relaxation des Puffers erreicht. Auch ist die Gitterkonstante a1 der ersten Halbleiter-Solarzelle 20 um wenigstens 0,008 Å kleiner als die Gitterkonstante a2 der zweiten Halbleiter-Solarzelle 30.

Die Abbildung der Figur 1c zeigt den Verlauf einer Dotierung D in der Einheit N/cm³ für die Schichten des metamorphen Puffers 40, dargestellt in der Figur 1a. Nachfolgend werden nur die Unterschiede zu der Ausführungsform, dargestellt in der Abbildung der Figuren 1a und 1b, erläutert. Es sei angemerkt, dass bei einer Änderung der Dotierung D zwischen den Schichten des Puffers der Unterschied in der Konzentration wenigstens größer als 4E17 N/cm³ ist.

Ausgehend von einer ersten geringen Konzentration oder einer intrinsischen Konzentration von Dotierstoffen dp1 in der ersten Schicht 41 des Puffers 40 springt an dem Übergang von der ersten Schicht 41 zu der zweiten Schicht 42 die Dotierung D auf eine im Vergleich zu der Dotierung dp1 der ersten Schicht 41 größeren Dotierung dp2 der zweiten Schicht 42.

An dem Übergang von der zweiten Schicht 42 zu der dritten Schicht 43 springt die Dotierung D auf eine im Vergleich zu der Dotierung dp2 der zweiten Schicht 42 größere Dotierung dp3 der dritten Schicht 43.

An dem Übergang von der dritten Schicht 43 zu der vierten Schicht 44 springt die Dotierung D auf eine im Vergleich zu der Dotierung dp3 der dritten Schicht 43 größere Dotierung dp4 der vierten Schicht 44. Hiernach verharrt die Dotierung dp5 der fünften Schicht 45 auf dem Niveau der vierten Schicht 44. Anders ausgedrückt, zwischen der vierten Schicht 44 und der fünften Schicht 45 besteht hinsichtlich der Konzentration der Dotierstoffe kein Unterschied und es gilt dp4 = dp5.

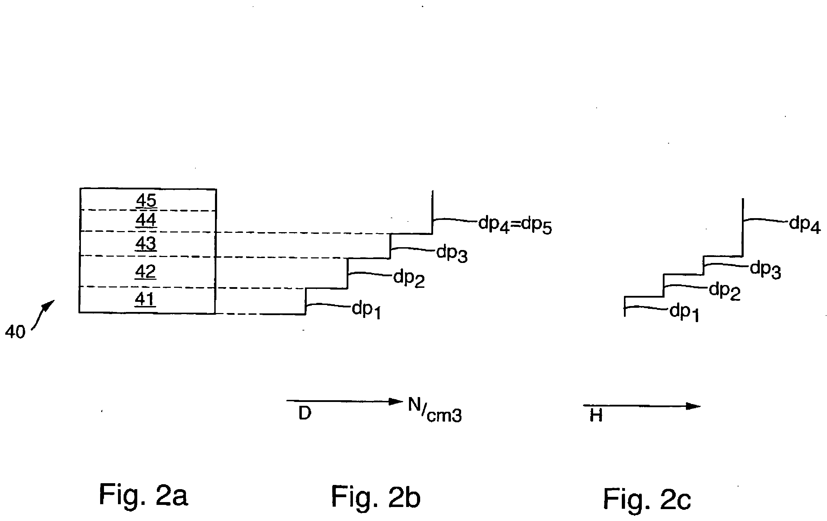

Die Abbildung der Figur 2a zeigt eine zweite Ausführungsform des metamorphen Puffers 40. Nachfolgend werden nur die Unterschiede zu den vorangegangenen Ausführungsformen erläutert. Der Puffer 40 weist insgesamt wiederum fünf Schichten 41, 42, 43, 44 und 45 auf.

Die Abbildung der Figur 2b zeigt den Verlauf der Dotierung D für die zweite Ausführungsform des metamorphen Puffers 40, dargestellt in der Figur 2a. Nachfolgend werden nur die Unterschiede zu den vorangegangenen Ausführungsformen erläutert. Die Dotierung D nimmt in Sprüngen von 1E16 N/cm³ < ΔD <5e17 N/cm³ von einer Schicht des Puffers 40 zu einer nachfolgenden Schicht des Puffers 40 bis einschließlich der vierten Schicht 44 zu. Die Dotierung dp4 und dp5 für die letzten beiden Schichten 44 und 45 des Puffers 40 ist dann jedoch konstant.

Die Abbildung der Figur 2c zeigt den Verlauf der Härte H für die zweite Ausführungsform des Puffers 40, dargestellt in der Figur 2a. Die Härte H nimmt sprungartig von der ersten Schicht 41 zu der zweiten Schicht 42 und von der zweiten Schicht 42 zu der dritten Schicht 43 und von der dritten Schicht 43 zu der vierten Schicht 44 des Puffers 40 zu, wobei die Härte H für die letzten belden Schichten 44 und 45 des Puffers 40 konstant bleibt.

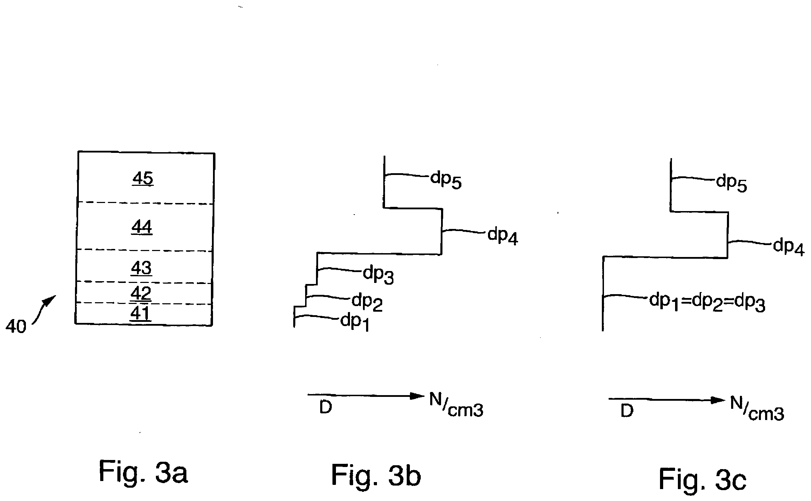

Die Abbildung der Figur 3a zeigt eine dritte Ausführungsform des metamorphen Puffers 40. Nachfolgend werden nur die Unterschiede zu den vorangegangenen Ausführungsformen erläutert. Vorliegend sind die vierte Schicht 44 und die fünfte Schicht 45 jeweils etwas dicker als die anderen Schichten des Puffers 40 ausgebildet.

Die Abbildung der Figur 3b zeigt den Verlauf der Dotierung D für die dritte Ausführungsform des metamorphen Puffers, dargestellt in der Figur 3a. Nachfolgend werden nur die Unterschiede zu den vorangegangenen Ausführungsformen erläutert. Die Dotierung D nimmt in Sprüngen von 1E16 N/cm³ < ΔD <5e16 N/cm³ von einer Schicht des Puffers 40 zu einer nachfolgenden Schicht des Puffers 40 bis einschließlich der dritten Schicht 43 zu. Die Dotierung macht ausgehend von der dritten Schicht 43 hinzu der vierten Schicht 44 einen Sprung zu größerer Konzentration um wenigstens das fünffache der Konzentration des Dotierstoff in der dritten Schicht 43, vorzugsweise nimmt die Dotierung von der dritten Schicht 43 zu der Dotierung dp4 der vierten Schicht 44 um wenigstens den Faktor 10 zu.

Die Abbildung der Figur 3c zeigt den Verlauf der alternativen Dotierung D für die dritte Ausführungsform des metamorphen Puffers, dargestellt in der Figur 3a. Nachfolgend werden nur die Unterschiede zu den vorangegangenen Ausführungsformen erläutert. Die Dotierung D ist von der ersten Schicht 41 bis einschließlich der dritten Schicht 43 konstant niedrig oder intrinsisch und macht ausgehend von der dritten Schicht 43 hinzu der vierten Schicht 44 einen Sprung zu größerer Konzentration um wenigstens 1E18 N/cm³.

## Patentansprüche

1. Solarzellenstapel (10) aufweisend
- eine erste Halbleiter-Solarzelle (20), wobei die erste Halbleiter-Solarzelle (20) einen p-n Übergang aus einem ersten Material mit einer ersten Gitterkonstanten (a1) aufweist, und
- eine zweite Halbleiter-Solarzelle (30), wobei die zweite Halbleiter-Solarzelle (30) einen p-n Übergang aus einem zweiten Material mit einer zweiten Gitterkonstanten (a2) aufweist, und
- die erste Gitterkonstante (a1) um mindestens 0,008 Å kleiner als die zweite Gitterkonstante (a2) ist, und
- als Substratschicht Ge oder GaAs vorgesehen sind und die erste Halbleiter-Solarzelle (20) und/oder die zweite Halbleiter-Solarzelle (30) aus den Materialien Ge und/oder GaAs und/oder InGaAs und/oder InGaP bestehen, und
- die Halbleiter-Solarzellen (20, 30) monolithisch integriert sind, und
- einen metamorphen Puffer (40), wobei der metamorphe Puffer (40) zwischen der ersten Halbleiter-Solarzelle (20) und der zweiten Halbleiter-Solarzelle (30) ausgebildet ist, und
- der metamorphe Puffer (40) wenigstens fünf Schichten (41, 42, 43, 44, 45) umfasst,
- der metamorphe Puffer (40) bei der Abfolge von drei Schichten (41, 42, 43) die Gitterkonstanten (ap1, ap2, ap3) in Richtung der zweiten Halbleitersolarzelle (30) ansteigen,
- die Gitterkonstanten der Schichten (ap1, ap2, ap3, ap4, ap5) des metamorphen Puffers (40) größer als die erste Gitterkonstante (a1) sind,
**dadurch gekennzeichnet, dass**
- zwei Schichten des metamorphen Puffers eine Dotierung (D) aufweisen und wobei der Unterschied in der Dotierstoffkonzentration zwischen den beiden Schichten größer als 4E17 cm-³ ist, und
- die Konzentration der Dotierstoffe (D) über die Abfolge der mehreren Schichten des metamorphen Puffers (40) von Schicht zu Schicht erst zunimmt und anschließend wieder abnimmt oder erst zunimmt und bei den letzten beiden Schichten (44, 45) des metamorphen Puffers (40) konstant ist.

2. Solarzellenstapel (10) nach Anspruch 1, **dadurch gekennzeichnet, dass** eine Schicht (44) des metamorphen Puffers (40) eine vierte Gitterkonstante (ap4) aufweist und die vierte Gitterkonstante (ap4) größer ist als die Gitterkonstante (ap2) der zweiten Halbleiter-Solarzelle (20).

3. Solarzellenstapel (10) nach einem der vorangegangenen Ansprüche, **dadurch gekennzeichnet, dass** die Gitterkonstante (A) des metamorphen Puffers (40) in Richtung der zweiten Halbleitersolarzelle (30) von Schicht zu Schicht um jeweils mindestens 0,003 Å ansteigt.

4. Solarzellenstapel (10) nach einem der vorangegangenen Ansprüche, **dadurch gekennzeichnet, dass** bei zwei unmittelbar aufeinanderfolgende Schichten des metamorphen Puffers (40) die beiden Schichten eine unterschiedliche Konzentration der Dotierstoffe (D) aufweisen.

5. Solarzellenstapel (10) nach einem der vorangegangenen Ansprüche, **dadurch gekennzeichnet, dass** bei zwei unmittelbar aufeinanderfolgende Schichten des Puffers (40) der Unterschied in der Konzentration der Dotierstoffe (D) größer als der Faktor fünf ist.

6. Solarzellenstapel (10) nach einem der vorangegangen Ansprüche, **dadurch gekennzeichnet, dass** die Schichten des metamorphen Puffers (40) eine n-Dotierung oder eine p-Dotierung aufweisen.

7. Solarzellenstapel (10) nach einem der vorangegangen Ansprüche, **dadurch gekennzeichnet, dass** im metamorphen Puffer (40) als p-Dotierstoffe Zn und/oder C und/oder Mg und/oder Be und als n-Dotierstoffe Si und/oder Te und/oder Se vorgesehen sind.

8. Solarzellenstapel (10) nach einem der vorangegangen Ansprüche, **dadurch gekennzeichnet, dass** die Konzentration der Dotierstoffe innerhalb der jeweiligen Schicht des metamorphen Puffers konstant ist.

9. Solarzellenstapel (10) nach einem der vorangegangen Ansprüche, **dadurch gekennzeichnet, dass** der metamorphe Puffer (40) mehr als fünf Schichten umfasst.

10. Solarzellenstapel (10) nach einem der vorangegangenen Ansprüche, **dadurch gekennzeichnet, dass** die metamorphen Pufferschichten (40) nicht Teil eines pn-Übergangs einer Tunneldiode sind.

11. Solarzellenstapel (10) nach einem der vorangegangenen Ansprüche, **dadurch gekennzeichnet, dass** die Konzentration der Dotierstoffe (D) innerhalb der metamorphen Pufferschichten 1E19 cm⁻³ nicht überschreitet.

12. Solarzellenstapel (10) nach einem der vorangegangenen Ansprüche, **dadurch gekennzeichnet, dass** ein optischer Rückseitenspiegel ausgebildet ist.

13. Solarzellenstapel (10) nach Anspruch 12, **dadurch gekennzeichnet, dass** der optische Rückseitenspiegel unterhalb der Halbleiter-Solarzellen (20,30) mit der kleinsten Bandlückenenergie angeordnet ist und aus einem Metall ausgebildet ist.

## Claims

1. Solar cell stack (10) comprising
- a first semiconductor solar cell (20), wherein the first semiconductor solar cell (20) has a p-n transition of a first material with a first lattice constant (a1), and
- a second semiconductor solar cell (30), wherein the second semiconductor solar cell (30) has a p-n transition of a second material with a second lattice constant (a2), and
- the first lattice constant (a1) is smaller than the second lattice constant (a2) by at least 0.008 Å, and
- Ge or GaAs is provided as substrate layer and the first semiconductor solar cell (20) and/or the second semiconductor solar cell (30) consists or consist of the materials Ge and/or GaAs and/or InGaAs and/or InGaP, and
- the semiconductor solar cells (20, 30) are monolithically integrated, and
- a metamorphic buffer (40), wherein the metamorphic buffer (40) is formed between the first semiconductor solar cell (20) and the second semiconductor solar cell (30), and
- the metamorphic buffer (40) comprises at least five layers (41, 42, 43, 44, 45),
- with respect to the metamorphic buffer (40) in the case of the sequence of three layers (41, 42, 43) the lattice constants (ap1, ap2, ap3) increase in the direction of the second semiconductor solar cell (30),
- the lattice constants (ap1, ap2, ap3, ap4, ap5) of the layers of the metamorphic buffer (40) are greater than the first lattice constant (a1),
**characterised in that**
- two layers of the metamorphic buffer have a doping (D), wherein the difference in the dopant concentration between the two layers is greater than 4E17 cm⁻³, and
- the concentration of the dopant (D) over the sequence of the plurality of layers of the metamorphic buffer (40) initially increases from layer to layer and subsequently decreases again or initially increases and is constant in the case of the last two layers (44, 45) of the metamorphic buffer (40).

2. Solar cell stack (10) according to claim 1, **characterised in that** a layer (44) of the metamorphic buffer (40) has a fourth lattice constant (ap4) and the fourth lattice constant (ap4) is greater than the lattice constant (ap2) of the second semiconductor solar cell (20).

3. Solar cell stack (10) according to one of the preceding claims, **characterised in that** the lattice constant (A) of the metamorphic buffer (40) increases in the direction of the second semiconductor solar cell (30) from layer to layer by in each instance at least 0.0003 Å.

4. Solar cell stack (10) according to any one of the preceding claims, **characterised in that** in the case of two directly successive layers of the metamorphic buffer (40) the two layers have a different concentration of the dopant (D).

5. Solar cell stack (10) according to any one of the preceding claims, **characterised in that** in the case of two directly successive layers of the buffer (40) the difference in the concentration of the dopant (D) is greater than the factor five.

6. Solar cell stack (10) according to any one of the preceding claims, **characterised in that** the layers of the metamorphic buffer (40) have an n-doping or a p-doping.

7. Solar cell stack (10) according to any one of the preceding claims, **characterised in that** in the metamorphic buffer (40) Zn and/or C and/or Mg and/or Be is or are provided as p-dopant and Si and/or Te and/or Se is or are provided as n-dopant.

8. Solar cell stack (10) according to any one of the preceding claims, **characterised in that** the concentration of the dopants within the respective layer of the metamorphic buffer is constant.

9. Solar cell stack (10) according to any one of the preceding claims, **characterised in that** the metamorphic buffer (40) comprises more than five layers.

10. Solar cell stack (10) according to any one of the preceding claims, **characterised in that** the metamorphic buffer layers (40) are not part of a pn transition of a tunnel diode.

11. Solar cell stack (10) according to any one of the preceding claims, **characterised in that** the concentration of the dopants (D) within the metamorphic buffer layers does not exceed 1E19 cm⁻³.

12. Solar cell stack (10) according to any one of the preceding claims, **characterised in that** an optical rear-side mirror is formed.

13. Solar cell stack (10) according to claim 12, **characterised in that** the optical rear-side mirror is arranged below the semiconductor solar cells (20, 30) with the smallest band gap energy and is made from a metal.

## Revendications

1. Empilement de cellules solaires (10) comprenant :
- une première cellule solaire à semi-conducteur (20), la première cellule solaire à semi-conducteur (20) comportant une jonction p-n constituée d'un premier matériau ayant une première constante de réseau (a1), et
- une deuxième cellule solaire à semi-conducteur (30), la deuxième cellule solaire à semi-conducteur (30) comportant une jonction p-n constituée d'un deuxième matériau ayant une seconde constante de réseau (a2), et
- la première constante de réseau (a1) étant inférieure d'au moins 0,008 Å à la seconde constante de réseau (a2), et
- du Ge ou du GaAs sont prévus comme couche de substrat et la première cellule solaire à semi-conducteur (20) et/ou la deuxième cellule solaire à semi-conducteur (30) sont constituées des matériaux Ge et/ou GaAs et/ou InGaAs et/ou InGaP, et
- les cellules solaires à semi-conducteur (20, 30) sont intégrées de manière monolithique, et
- un tampon métamorphique (40), le tampon métamorphique (40) étant formé entre la première cellule solaire à semi-conducteur (20) et la deuxième cellule solaire à semi-conducteur (30), et
- le tampon métamorphique (40) comprend au moins cinq couches (41, 42, 43, 44, 45),
- le tampon métamorphique (40) présentant, dans la séquence de trois couches (41, 42, 43), des constantes de réseau (ap1, ap2, ap3) croissantes en direction de la deuxième cellule solaire à semi-conducteur (30),
- les constantes de réseau (ap1, ap2, ap3, ap4, ap5) du tampon métamorphique (40) sont supérieures à la première constante de réseau (a1),
**caractérisé en ce que**
- deux couches du tampon métamorphique présentent un dopage (D) et la différence de concentration en dopant entre les deux couches est supérieure à 4E17 cm⁻³, et
- la concentration des dopants (D) augmente d'abord d'une couche à l'autre sur la séquence des multiples couches du tampon métamorphique (40), puis diminue à nouveau ou augmente d'abord et reste constante dans les deux dernières couches (44, 45) du tampon métamorphique (40).

2. Empilement de cellules solaires (10) selon la revendication 1, **caractérisé en ce qu'**une couche (44) du tampon métamorphique (40) présente une quatrième constante de réseau (ap4) et la quatrième constante de réseau (ap4) est supérieure à la constante de réseau (ap2) de la deuxième cellule solaire à semi-conducteur (20).

3. Empilement de cellules solaires (10) selon l'une des revendications précédentes, **caractérisé en ce que** la constante de réseau (A) du tampon métamorphique (40) augmente d'au moins 0,003 Å d'une couche à l'autre en direction de la deuxième cellule solaire à semi-conducteur (30).

4. Empilement de cellules solaires (10) selon l'une des revendications précédentes, **caractérisé en ce que**, dans le cas de deux couches immédiatement consécutives du tampon métamorphique (40), les deux couches présentent une concentration différente en dopants (D).

5. Empilement de cellules solaires (10) selon l'une des revendications précédentes, **caractérisé en ce que**, dans le cas de deux couches successives du tampon (40), la différence de concentration des dopants (D) est supérieure à un facteur cinq.

6. Empilement de cellules solaires (10) selon l'une des revendications précédentes, **caractérisé en ce que** les couches du tampon métamorphique (40) présentent un dopage n ou un dopage p.

7. Empilement de cellules solaires (10) selon l'une des revendications précédentes, **caractérisé en ce que** le tampon métamorphique (40) contient comme dopants p du Zn et/ou du C et/ou du Mg et/ou du Be et comme dopants n du Si et/ou du Te et/ou du Se.

8. Empilement de cellules solaires (10) selon l'une des revendications précédentes, **caractérisé en ce que** la concentration des dopants à l'intérieur de la couche respective du tampon métamorphique est constante.

9. Empilement de cellules solaires (10) selon l'une des revendications précédentes, **caractérisé en ce que** le tampon métamorphique (40) comprend plus de cinq couches.

10. Empilement de cellules solaires (10) selon l'une des revendications précédentes, **caractérisé en ce que** les couches tampons métamorphiques (40) ne font pas partie d'une jonction p-n d'une diode tunnel.

11. Empilement de cellules solaires (10) selon l'une des revendications précédentes, **caractérisé en ce que** la concentration des dopants (D) à l'intérieur des couches tampons métamorphiques ne dépasse pas 1E19 cm⁻³.

12. Empilement de cellules solaires (10) selon l'une des revendications précédentes, **caractérisé en ce qu'**un miroir optique arrière est formé.

13. Empilement de cellules solaires (10) selon la revendication 12, **caractérisé en ce que** le miroir optique arrière est disposé sous les cellules solaires à semiconducteurs (20, 30) ayant la plus petite énergie de bande interdite et est formé d'un métal.
